# EUROPEAN PATENT SPECIFICATION

(11) **EP 1 158 257 B1**
(45) Date of publication and mention of the grant of the patent: **27.10.2004**
(21) Application number: 99935126.5
(22) Date of filing: 10.08.1999
(51) Int. Cl.: F26B 21/00, H01L 21/304

(54) **METHOD FOR DRYING SUBSTRATE**
VERFAHREN ZUR TROCKNUNG EINES SUBSTRATS
TECHNIQUE DE SECHAGE DE SUBSTRAT

(30) Priority: 18.01.1999 JP 933899; 28.04.1999 JP 12269699
(43) Date of publication of application: 28.11.2001
(73) Proprietor: Toho Kasei Ltd., Yamatokouriyama-shi, Nara 639-1031 (JP); Daikin Industries, Ltd., Osaka-shi, Osaka 530-8323 (JP)
(72) Inventor: MAEDA, Norio, Yamatokouriyama-shi, Nara 639-1031 (JP); SUMI, Koji, Yamatokouriyama-shi, Nara 639-1031 (JP); AIHARA, Hiroshi, Kanaoka Koujou, Sakai Seisakusho, Sakai-shi, Osaka 591-8022 (JP); OONO, Masao, Kanaoka Koujou, Sakai Seisakusho, Sakai-shi, Osaka 591-8022 (JP); IZUTANI, Naoaki, Kanaoka Koujou, Sakai Seisakusho, Sakai-shi, Osaka 591-8022 (JP)
(74) Representative: Prüfer, Lutz H., Dipl.-Phys.
(86) International application number: PCT/JP1999/004335
(87) International publication number: WO 2000/042373

(56) References cited:
- WO-A-97/33702
- JP-A- 6 181 198
- JP-A- 9 275 084
- JP-A- 10 308 378
- JP-A- 10 335 299
- JP-A- 63 301 528
- US-A- 5 520 744
- US-A- 5 571 337
- US-A- 5 634 978
- US-A- 5 685 086

## Description

### Technical Field

The present invention relates to a method for drying substrates. More particularly, the present invention relates to a method for rapidly drying substrates which are cleaned using cleaning fluid.

### Related Art

From the past, a device having an arrangement which is illustrated in Japanese Patent Publication JP-A-3 169 013 is proposed as a device for drying substrates (for example, semiconductor wafers or the like) after cleaning of the substrates using cleaning fluid, by relatively lowering the fluid surface of the cleaning fluid with respect to the substrates and by supplying drying fluid vapour {for example, isopropyl alcohol (hereinafter referred to as IPA) vapour or the like}.

When the device is employed, a plurality of substrate housed within a processing container is cleaned using the cleaning fluid, then the drying fluid vapour is introduced within the processing container and the fluid surface of the cleaning fluid is lowered, both operations are carried out simultaneously, so that a thin fluid layer of drying fluid is generated on the fluid surface of the cleaning fluid. Consequently, the surface of each substrate is rapidly dried using MARANGONI effect.

When the device having the arrangement illustrated in Japanese Patent Publication JP-A-3 169 013 is employed, not only an introducing passage for introducing drying vapour but also a relief valve (exhaust opening) for exhausting drying vapour are needed for forming a flowing passage of drying vapour within the processing container so that the arrangement becomes complicated and that a dangerous condition is realized in which the drying vapour leaks within a factory.

Further, when the device is applied for drying a plurality of semiconductor wafers, the semiconductor wafers are enlarged in size, and an interval of semiconductor wafers is decreased for increasing a number of semiconductor wafers which are processed simultaneously, in recent years. Under such condition, a disadvantage arises in that intruding of the drying vapour between semiconductor wafers becomes difficult so as to generate a drying mark on the semiconductor wafers.

WO 97 33702 A discloses a method for drying sub-strates according to the preamble of claim 1. In this document, the drying fluid is introduced into the processing container by means of a vibrating nozzle. In a specific embodiment, a housing directs inert gas towards the already formed aerosol droplets.

The Patent Abstract of Japan, Vol. 199 No. 903 & JP 10 335299 A describes a method for drying substrate in which a mist of isopropyl alcohol as the drying fluid in N₂ gas is produced preliminary in a separate device, before being supplied to a line into the processing chamber.

The present invention was made in view of the above problems.

It is an object of the present invention to offer a method for drying substrates in which an exhaust equipment is eliminated or simplified and for smoothly supplying drying fluid.

### Disclosure of the Invention

The object is solved by a method for drying substrates according to claim 1. Preferred embodiments are set forth in sub-claim 2.

When the method for drying substrates of claim 1 is employed, the substrates are housed within the processing container, and the surface of each substrate is dried by relatively lowering the fluid surface of the cleaning fluid within the processing container with respect to the substrates and by introducing the drying fluid within the processing container. During this operation, the method introduces drying fluid under a liquid condition within the processing container, and injects the introduced drying fluid onto the fluid surface of the cleaning fluid using a nozzle. Therefore, the drying fluid is smoothly introduced between the substrates due to the influence of dead weight of the liquid drying fluid so -that the drying fluid is supplied with higher density with respect to the density of the vapor supplying so as to improve MARANGONI effect. Consequently, a liquid layer of the drying fluid is generated on the cleaning fluid so that drying of the substrates with greatly little drying mark is rapidly realized using MARANGONI effect. Further, the drying fluid is supplied in a liquid phase condition, so that the entirety or almost all of the drying fluid is discharged with the cleaning fluid. Consequently, leakage of the drying fluid is decreased up to nearly zero so that exhaust equipment is eliminated or is simplified. As a result, decrease in cost is realized.

Furthermore, the method for drying substrates of claim 1 blows inert gas for atomizing the drying fluid. Therefore, disadvantage is prevented from occurrence that droplet of the injected liquid drying fluid becomes too large, so that superior drying of the substrates is realized.

Furthermore, the blowing quantity of the drying fluid from the blowing opening of the nozzle is suppressed so that the drying fluid of proper quantity is supplied to the dipping boundary face of the substrates. Consequently, usage quantity of the drying fluid is decreased and the running cost is decreased.

When the method for drying substrates of claim 1 is employed, the method intermittently introduces the drying fluid within the processing container. Therefore, increase in consumption quantity of the drying fluid following the supplying of the drying fluid in a liquid condition is suppressed.

### Brief Description of the Drawings

Figure 1 is a schematic perspective view of a device for drying substrates;
Figure 2 is a schematically vertical cross sectional view illustrating another arrangement of an injection nozzle;
Figure 3 is a schematic vertical cross sectional view illustrating a further arrangement of an injection nozzle;
Figure 4 is a schematic vertical cross sectional view illustrating yet another arrangement of an injection nozzle;
Figure 5 is a schematic perspective view of a device for drying substrates;
Figure 6 is a schematic perspective view of a device for drying substrates;
Figure 7 is a schematic perspective view of a device for drying substrates;
Figure 8 is a schematic perspective view of a device for drying substrates;
Figure 9 is a timing chart useful in understanding intermittent introduction of drying fluid and intermittent blowing of high temperature nitrogen gas;
Figure 10 is a perspective view illustrating a main portion of a device for drying substrates;
Figure 11 is a perspective view illustrating a main portion of a device for drying substrates; and
Figure 12 is a perspective view illustrating a main portion of a device for drying substrates.

### Best Mode for Carrying Out the Invention

Hereinafter, referring to the attached drawings, we explain a method for drying substrates of an embodiment according to the present invention in detail.

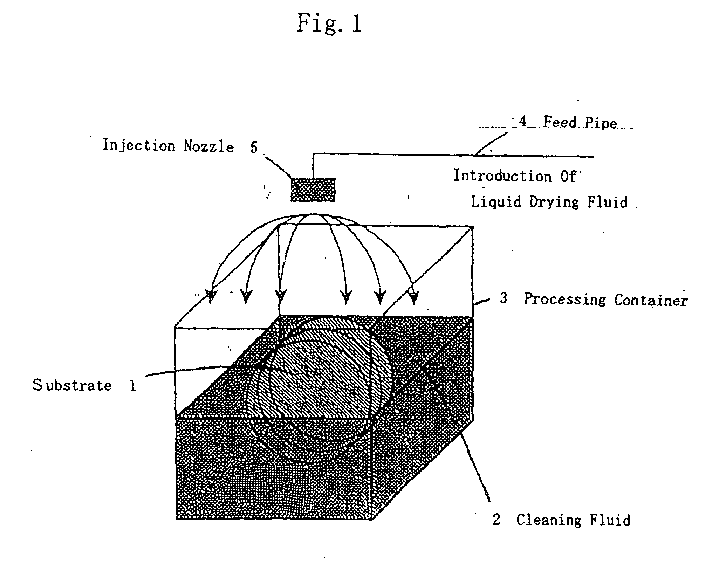

Fig. 1 is a schematic perspective view of a device for drying substrates.

The device for drying substrates has a processing container 3 for housing a plurality of substrates 1, and for discharging cleaning fluid (for example, pure water) 2 which has cleaned the substrates 1. The device also has a feed pipe 4 for supplying liquid drying fluid (for example IPA), and an injection nozzle 5 for injecting the drying fluid which is provided at the end section of the feed pipe 4. Of course, the injection nozzle 5 is disposed above the substrate 1.

Operation of the device for drying substrates having the above arrangement is as follows.

After the substrates 1 have been cleaned by housing the cleaning fluid 2 within the processing container 3 in which the substrates 1 are housed, the fluid surface of the cleaning fluid 2 is lowered by discharging the cleaning fluid 2 from the processing container 3 and the drying fluid is supplied through the feed pipe 4 and is injected by the injection nozzle 5. As a result, a fluid layer of the injected drying fluid is formed on the surface of the cleaning fluid 2 so that portions exposed from the surface of the cleaning fluid 2 among the plurality of substrates 1 are rapidly dried without drying mark due to MARANGONI effect.

When portions to some degree among the plurality of substrate 1 are positioned above the surface of the cleaning fluid 2, mist conditioned drying fluid injected from the injection nozzle 5 smoothly intrudes into the clearance between substrates 1 by the dead weight thereof so that a fluid layer of the injected drying fluid is formed on the surface of the cleaning fluid 2 for those portions. Therefore, rapid drying without drying mark due to MARANGONI effect is continued.

When the above series of drying operation is carried out, almost all of the drying fluid supplied in liquid condition is discharged with the cleaning fluid 2 from the processing container 3 to an outer section so that the drying fluid scarcely leaks neighboring sections with respect to the processing container 3. As a result, an exhausting equipment for exhausting the drying fluid is eliminated or simplified so as to realize decrease in cost.

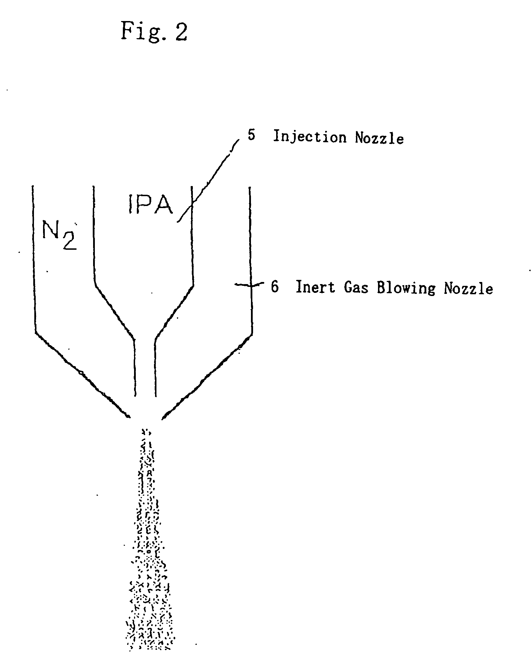

Fig. 2 is a schematic vertical cross sectional view illustrating another arrangement of an injection nozzle 5.

The injection nozzle 5 is surrounded by an inert gas blowing nozzle 6 for blowing inert gas (for example nitrogen gas) therefrom.

When the injection nozzle 5 having the above arrangement is employed, nitrogen blowing is carried out as inert gas blowing against the injected drying fluid so that the injected drying fluid is prevented from becoming too large in size. Therefore, drying of the substrates 1 with high quality is realized. Wherein, the nitrogen gas may be the nitrogen gas with usual temperature, but the nitrogen gas is preferable to be the nitrogen gas with increased temperature of about 100 °C so as to improve the above operation and effect.

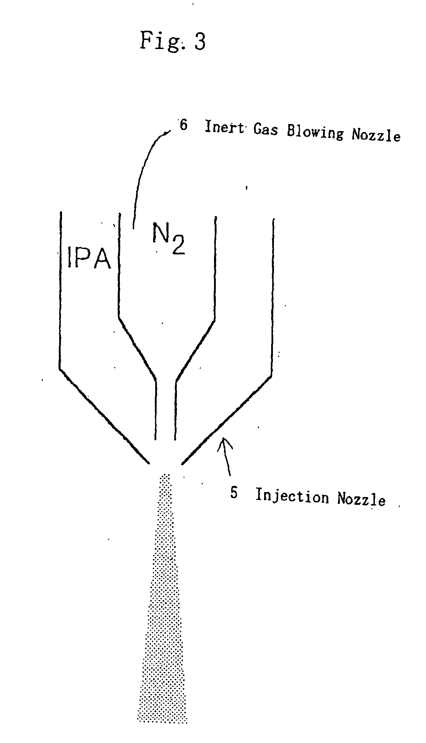

Fig. 3 is a schematic vertical cross sectional view illustrating a further arrangement of an injection nozzle 5.

The injection nozzle 5 surrounds an inert gas blowing nozzle 6 for blowing inert gas therefrom.

When the injection nozzle 5 having the above arrangement is employed, operation and effect are realized which are similar to those of the case in which the injection nozzle 5 illustrated in Fig. 2 is employed.

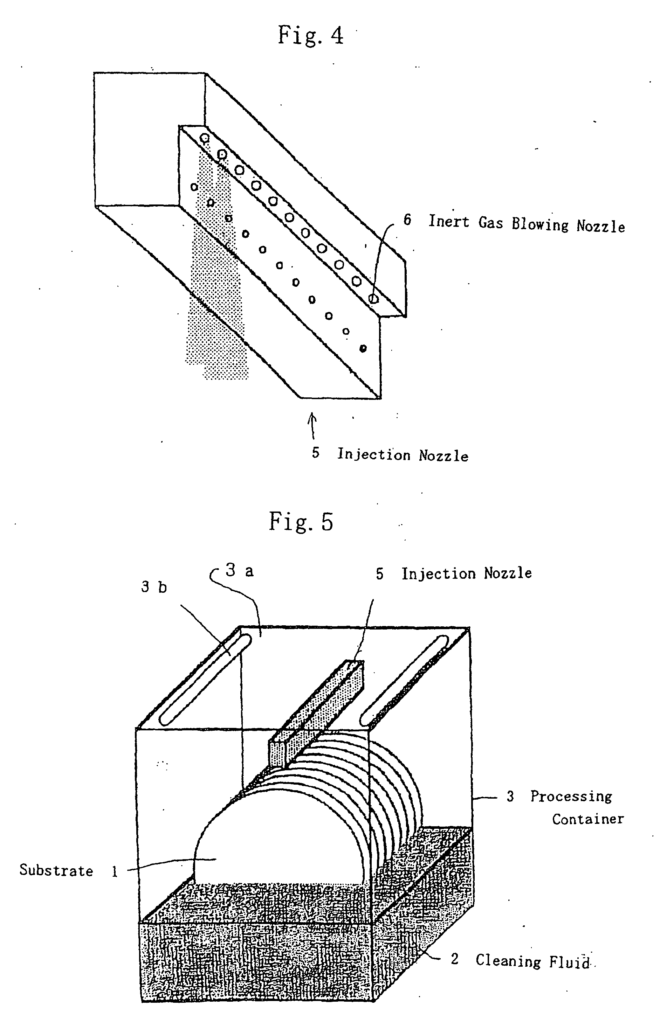

Fig. 4 is a schematic vertical cross sectional view illustrating yet another arrangement of an injection nozzle 5.

The injection nozzle 5 injects the drying fluid in a horizontal direction, and an inert gas blowing nozzle 6 is provided for blowing nitrogen gas with usual temperature or high temperature as inert gas from an upper position with respect to the injected drying fluid.

When the injection nozzle 5 having the above arrangement is employed, operation and effect are realized which are similar to those of the case in which the injection nozzle 5 illustrated in Fig. 2 is employed.

Fig. 5 is a schematic perspective view of a device for drying substrates.

The device for drying substrate is different from the one illustrated in Fig. 1 in that the injection nozzle 5 having the arrangement of one of Figs. 2 ∼ 4 is employed, and that an exhausting slit opening 3b is provided at a predetermined position of a cover body 3a of the processing container 3.

When the device for drying substrates having the above arrangement is employed, steady flow of the inert gas is formed by exhausting the inert gas through the exhausting slit opening 3b which inert gas is introduced within the processing container 3 by inert gas blowing. Consequently, the injected drying fluid is prevented from becoming too large in size. As a result, rapid drying without drying mark of the substrates 1 is realized.

When the above arrangement is employed, there is a possibility that the drying fluid is exhausted through the exhausting slit opening 3b. But, the quantity of the drying fluid exhausted through the exhausting slit opening 3b is remarkably small so that disadvantage does not arise, because almost all of the drying fluid is injected towards the surface of the cleaning fluid 2 so as to form the fluid layer on the surface.

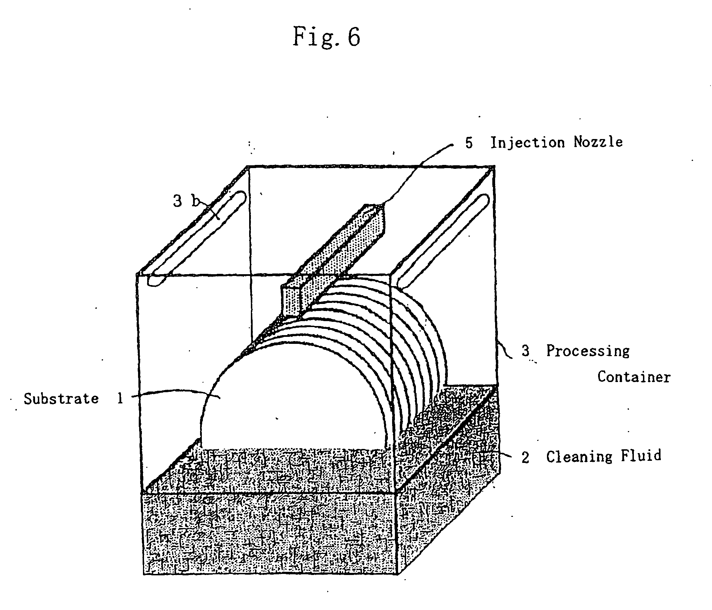

Fig. 6 is a schematic perspective view of a device for drying substrates.

The device for drying substrate is different from the one illustrated in Fig. 5 in that an exhausting slit opening 3b is provided at an upper section of a side wall of the processing container 3.

When this arrangement is employed, operation and effect are realized which are similar to those of the device for drying substrates illustrated in Fig. 5.

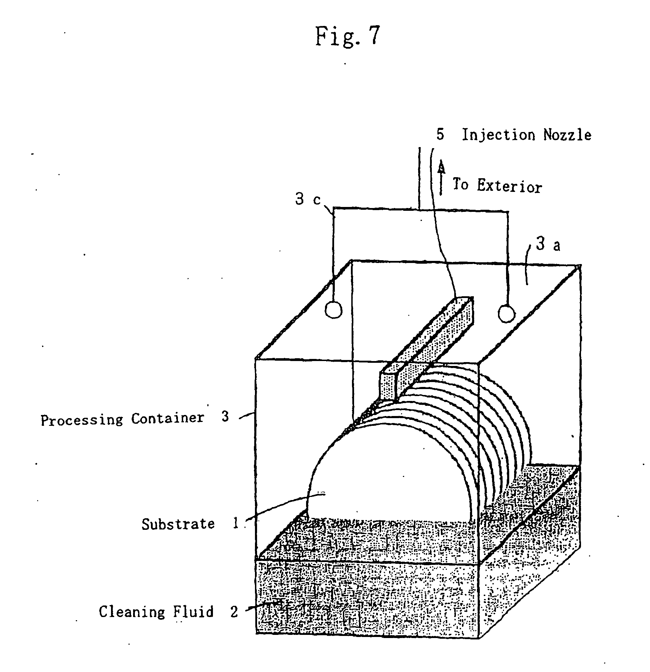

Fig. 7 is a schematic perspective view of a device for drying substrates.

The device for drying substrates is different from the one illustrated in Fig. 5 in that an exhausting pipe 3c is provided at a predetermined position of a cover body 3a of the processing container 3.

When this arrangement is employed, leakage of the drying fluid is securely prevented. In addition, operation and effect are realized which are similar to those of the device for drying substrates illustrated in Fig. 5.

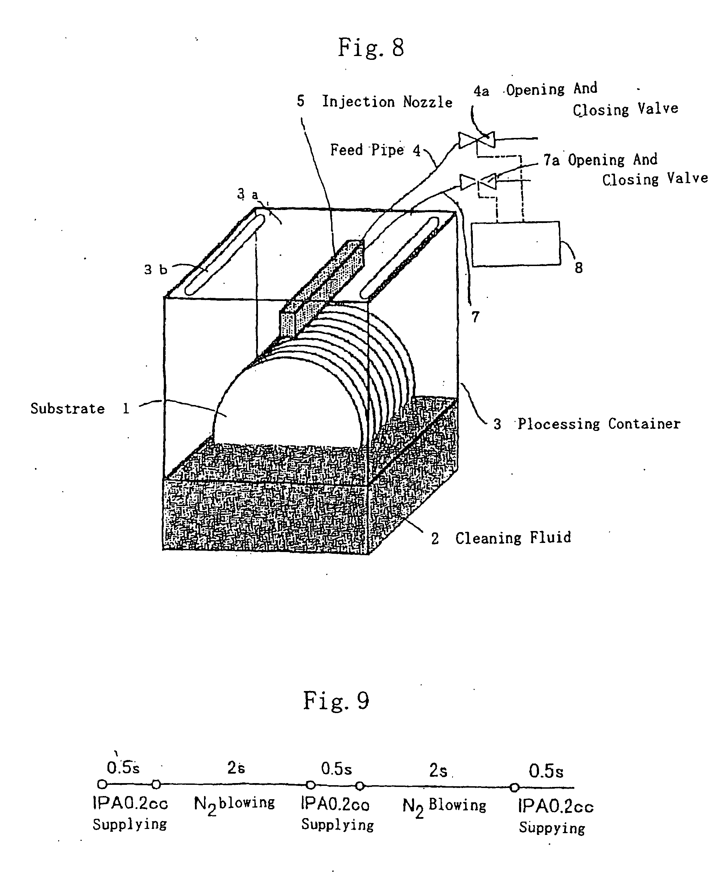

Fig. 8 is a schematic perspective view of a device for drying substrates.

The device for drying substrates is different from the embodiment illustrated in Fig. 5 in that an opening and closing valve 4a is provided at a predetermined position of the feed pipe 4 for supplying drying fluid to the injection nozzle 5, that an opening and closing valve 7a is provided at a predetermined position of a feed pipe 7 for supplying nitrogen gas to the nitrogen gas blowing nozzle 6, and that a valve control section 8 is provided for controlling the opening and closing valves 4a and 7a.

When the device for drying substrates having the above arrangement is employed, the drying fluid is intermittently introduced within the processing container 3 by periodically opening and closing the opening and closing valve 4a. Therefore, consumption quantity of the drying fluid is decreased in comparison with consumption quantity of the drying fluid when it is continuously introduced.

Specifically, as is illustrated in Fig. 9 for example, injection of the drying fluid is carried out for 0.5 seconds, then blowing of only the nitrogen gas with high temperature is carried out for 2 seconds, thereafter the valve control section 8 controls both opening and closing valves 4a and 7a so as to repeat the injection of the drying fluid and the blowing of only the nitrogen gas with high temperature. When this operation is carried out, the consumption quantity of the drying fluid and the consumption quantity of the nitrogen gas with high temperature are decreased in comparison with the consumption quantity of the drying fluid and the consumption quantity of the nitrogen gas with high temperature when the drying fluid is continuously introduced and when the nitrogen gas with high temperature is continuously blown for atomizing the drying fluid. The decreasing rate of the consumption quantity of the drying fluid is about 80%, while the decreasing rate of the consumption quantity of the nitrogen gas with high temperature is about 20%.

This specific example introduces the drying fluid for 0.5 seconds at every 2.5 seconds. The introduction interval of the drying fluid and the introduction quantity of the drying fluid at every introduction can be determined following. the lowering speed of the surface of the cleaning fluid for carrying out drying of the substrates due to MARANGONI effect.

In the above embodiments, the surface of the cleaning fluid 2 is lowered by discharging the cleaning fluid 2. Instead of the discharging of the cleaning fluid 2, it is possible that drying is carried out following moving upward of the plurality of substrates 1.

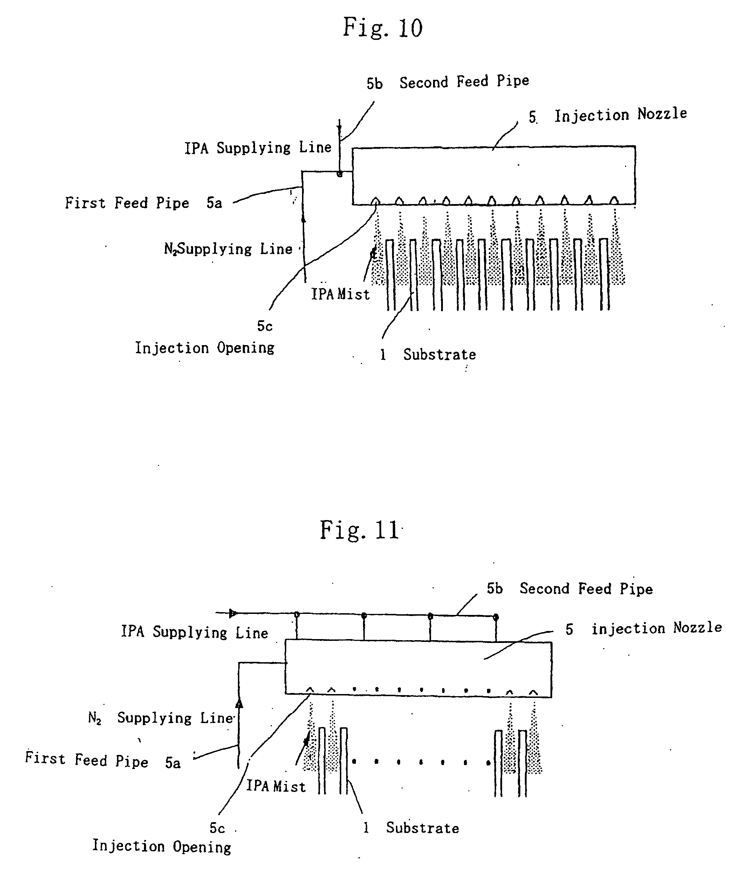

Fig. 10 is a perspective view illustrating a main portion of a device for drying substrates. The arrangement of each portion which is not illustrated is similar to that of the above one, therefore detailed description is omitted.

The device for drying substrate has a first feed pipe 5a for supplying carrier gas (for example nitrogen gas) to the injection nozzle 5, and a second feed pipe 5b for supplying liquid drying fluid, the second feed pipe 5b being communicated to halfway of the first feed pipe 5a. Further, the positions of the injection openings 5c of the injection nozzle 5 are determined so that the injection openings 5c correspond to clearances of the substrates 1.

When this device for drying substrates is employed, the carrier gas is supplied to the injection nozzle 5 through the first feed pipe 5a so as to generate negative pressure at the position corresponding to the opening of the second feed pipe 5b. Consequently, the liquid drying fluid is sucked into the first feed pipe 5a due to the negative pressure, then the drying fluid is supplied to the injection nozzle 5 with the carrier gas. Then, mist of the drying fluid is blown from the injection opening 5c of the injection nozzle 5. Drying of the substrates 1 is realized by the mist similar as the operation of the above embodiment.

When this embodiment is employed, blowing quantity of the drying fluid from the injection nozzle 5 is suppressed so that proper amount of the drying fluid is supplied to the dipping boundary face of each substrate 1. As a result, usage quantity of the drying fluid is decreased, and the running cost is decreased.

Fig. 11 is a perspective view illustrating a main portion of a device for drying substrates. The arrangement of each portion which is not illustrated is similar to that of the above arrangement, therefore detailed description is omitted.

The device for drying substrates has a first feed pipe 5a for supplying carrier gas to the injection nozzle 5, the first feed pipe 5a being communicated to one end face of the injection nozzle 5 in a longitudinal direction, and has a second feed pipe 5b for supplying liquid drying fluid, the second feed pipe 5b being communicated to a face of the injection nozzle 5 which face is neighboring to the one end face. Further, the positions of the injection openings 5c of the injection nozzle 5 are determined so that the injection openings 5c correspond to clearances of the substrates 1.

When this device for drying substrates is employed, the carrier gas is supplied to the injection nozzle 5 through the first feed pipe 5a so that the inner pressure within the injection nozzle 5 becomes high pressure because the injection openings 5c are small in size. And, liquid drying fluid is supplied into the injection nozzle 5 by supplying the liquid drying fluid with higher pressure with respect to the inner pressure through the second feed pipe 5b. Then, mist of the drying fluid is blown from the injection openings 5c of the injection nozzle 5. Drying. of the substrates 1 is realized by the mist similar as the operation of the above embodiment.

When this arrangement is employed, blowing quantity of the drying fluid from the injection nozzle 5 is suppressed so that proper amount of the drying fluid is supplied to the dipping boundary face of each substrate 1. As a result, usage quantity of the drying fluid is decreased, and the running cost is decreased.

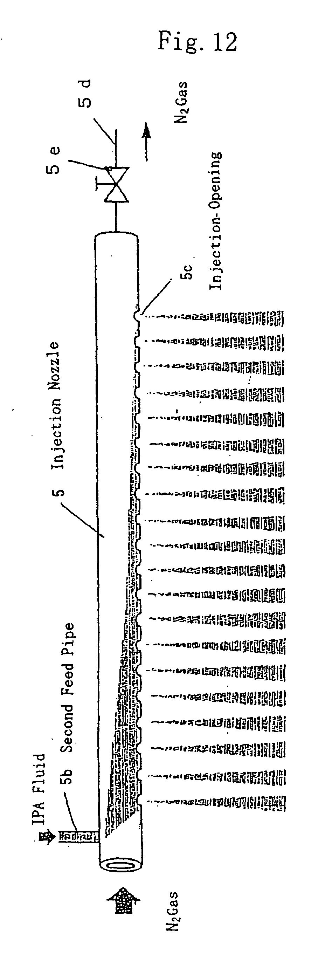

Fig. 12 is a perspective view illustrating a main portion of a device for drying substrates. The arrangement of each portion which is not illustrated is similar to that of the above arrangement, therefore detailed description is omitted.

The device for drying substrates is different from the device for drying substrates illustrated in Fig. 11 in that an exhaust pipe 5d is provided for exhausting carrier gas, the exhausting pipe 5d being communicated with the other end face of the injection nozzle 5 in a longitudinal direction, in that a valve 5e is provided at a predetermined position of the exhausting pipe 5d, and in that the second feed pipe 5b is communicated with the injection nozzle 5 only at the most upstream side thereof.

When this arrangement is employed, the rate of the carrier gas blown from the injection openings 5c and the carrier gas exhausted through the exhausting pipe 5d is controlled by controlling the opening of the valve 5e. The liquid drying fluid supplied to the injection nozzle 5 through the second supplying is accelerated by the carrier gas, and the liquid drying fluid is supplied in the entire extent from the most upstream side injection opening 5c to the most downstream side injection opening 5c, so that mist of drying fluid is blown from every injection opening 5c. Of course, the blown drying fluid is made to be fine mist by the carrier gas. Therefore, drying of the substrates 1 with high quality is realized.

### Industrial Applicability

The present invention can be applied to the drying of substrates such as semiconductor wafers or the like. Drying of the substrates with high quality is realized.

## Claims

1. A method for drying substrates, wherein the substrates (1) are housed within a processing container (3), and a surface of each substrate (1) is dried by relatively lowering the fluid surface of a cleaning fluid (2) within the processing container (3) with respect to the substrates (1) and by introducing a drying fluid within the processing container (3), the method comprising the steps of:
introducing the drying fluid under a liquid condition within the processing container (3), and
injecting the introduced drying fluid onto the surface of the cleaning fluid (2) using a nozzle (5), **characterized by**
conveying liquid drying fluid to the exhaust opening (5c) of the nozzle (5) using inert carrier gas, and by
blowing said inert carrier gas and said liquid drying fluid through said nozzle such that the drying fluid is atomized,
wherein introducing said drying fluid within the processing container (3) is carried out intermittently.

2. The method for drying substrates as said forth in claim 1, wherein
either the injection nozzle (5) is surrounded by an inert gas blowing nozzle (6), or the injection nozzle (5) surrounds an inert gas blowing nozzle (6) for blowing said inert gas therefrom such that the drying fluid is conveyed to the exhaust opening of the nozzle (5, 6).

## Patentansprüche

1. Verfahren zum Trocknen von Substraten, wobei die Substrate (1) in einem Prozessierbehälter (3) beherbergt sind, und eine Oberfläche von jedem Substrat (1) getrocknet wird durch relatives Absenken der Fluidoberfläche eines Reinigungsfluids (2) im Prozessierbehälter (3) in Bezug auf die Substrate (1) und durch Einführen eines Trocknungsfluids in den Prozessierbehälter (3), wobei das Verfahren die Schritte umfaßt:
Einführen des Trocknungsfluids unter einem flüssigen Zustand in den Prozessierbehälter (3), und
Injizieren des eingeführten Trocknungsfluids auf die Oberfläche des Reinigungsfluids (2) unter Verwendung einer Düse (5), **gekennzeichnet durch**
Befördern des flüssigen Trocknungsfluids zur Auslaßöffnung (5c) der Düse (5) unter Verwendung eines inerten Trägergases, und **durch**
Blasen des inerten Trägergases und des flüssigen Trocknungsfluids **durch** die Düse derart, daß das Trocknungsfluid atomisiert wird,
wobei das Zuführen des Trocknungsfluids in den Prozessierbehälter (3) intermittierend durchgeführt wird.

2. Verfahren zum Trocknen von Substraten wie im Anspruch 1 angegeben, wobei
entweder die Injektionsdüse (5) von einer Inertgas-Verblasdüse (6) umgeben wird, oder die Injektionsdüse (5) eine Inertgas-Verblasdüse (6) umgibt, zum Blasen des Inertgases davon, derart, daß das Trocknungsfluid zur Auslaßöffnung der Düse (5, 6) befördert wird.

## Revendications

1. Une méthode pour sécher des substrats, dans laquelle les substrats (1) sont logés dans un conteneur de traitement (3), et une surface de chaque substrat (1) est séchée en abaissant relativement la surface fluidique d'un fluide de nettoyage (2) à l'intérieur du conteneur de traitement (3) par rapport aux substrats (1) et en introduisant un fluide de séchage à l'intérieur du conteneur de traitement (3), la méthode comprenant les étapes de :
- introduction du fluide de séchage dans un état liquide à l'intérieur du conteneur de traitement (3), et
- injection du fluide de séchage introduit sur la surface du fluide de nettoyage (2) en utilisant une buse (5), **caractérisée par** :
- l'acheminement fluide liquide de séchage à l'ouverture d'échappement (5c) de la buse (5) en utilisant un gaz porteur inerte, et par
- le soufflage dudit gaz porteur inerte et audit fluide liquide de séchage à travers ladite buse de telle sorte que le fluide de séchage est atomisé ; et en ce que
- l'introduction dudit fluide de séchage à l'intérieur du conteneur de traitement (3) est opérée de manière intermittente.

2. La méthode de séchage des substrats selon la revendication 1, dans laquelle, soit la buse d'injection (5) est entourée par une buse de soufflement du gaz inerte (6), soit la buse d'injection (5) entoure une buse de soufflement du gaz inerte (6) pour souffler ledit gaz inerte depuis celle-ci de telle sorte que le fluide de séchage est acheminé à l'ouverture d'échappement de la buse (5, 6).
